# EUROPÄISCHE PATENTANMELDUNG

(11) **EP 2 187 447 A2**
(43) Veröffentlichungstag der Anmeldung: **19.05.2010**
(21) Anmeldenummer: 09075336.9
(22) Anmeldetag: 29.07.2009
(51) Int. Cl.: H01L 31/042

(54) **Montagevorrichtung für Solarmodule mit einem großen Aspektverhältnis.**

(30) Priorität: 13.08.2008 DE 102008037964
(71) Anmelder: SOLON SE, 12489 Berlin (DE)
(72) Erfinder: Schwarze, Sascha Oliver, 12277 Berlin (DE); Schäfer, Maik, 12247 Berlin (DE)

(57) **Zusammenfassung**

Bei der Verwendung von brettförmigen Solarmodulen verringern sich zu kompensierende Windlasten, sodass leichtere Montagevorrichtungen venrvendet werden können. Bekannt ist die Verwendung eines Einschubelements aus zwei gegenüberstehenden Klammern, die getrennt in eine Montageschiene eingeschraubt sind und in die ein Solarmodul vorgegebener Höhe mit seinen beiden Randbereichen seitlich eingeschoben wird. Zur Erreichung einer besseren Handhabbarkeit und einer größeren Modulvariabilität weist die erfindungsgemäße Montagevorrichtung ein Einschubelement (10) auf, das als kompaktes, einstückiges Formelement (12) mit einer geschlossenen Oberfläche (13) ausgeführt ist, die von einem unter einem vorgegebenen Einschubwinkel (11) verlaufenden Einschubschlitz (14) unterbrochen ist, in dem das mit einem längsverlaufenden Randbereich (06) eingeschobene Solarmodul (02) durch einen Kunststoffkeil (15), beispielsweise aus Vergussmasse, festgelegt ist. Durch den Einschubschlitz (14) können die Solarmodule (02), beispielsweise rahmenlosen Solarpaneelen (05), unabhängig von ihrer Höhe und ihrem Standort einfach von oben eingeschoben werden. Die kompakten Formelemente (12) sind einfach zu handhaben (Einstecken in die Montageschiene (09)), robust, können aus Kunststoff bestehen und haben ein ansprechendes Erscheinungsbild.

## Beschreibung

### BESCHREIBUNG

Die Erfindung bezieht sich auf eine Montagevorrichtung für Solarmodule mit einem großen Aspektverhältnis in Parallelanordnung auf einem flachen Horizontalsubstrat mit darauf angeordneten Montageschienen und an den Montageschienen an durch Durchgangsöffnungen vorgegebenen Stellen befestigten Einschubelementen zum Einschieben und Festlegen der Solarmodule in ihrem Randbereich.

Leichtgewichtige Flachdächer als flache Horizontalsubstrate können zur Sonne optimal ausgerichtete Standard-Solarmodule wegen fehlender Lastreserven nicht mehr tragen, sodass diese Flächen oft solartechnisch gar nicht oder nur mit flachliegenden und damit ertragsgeminderten Solarmodulen genutzt werden. Um die einwirkenden Lasten auf geneigt angeordnete Solarmodule möglichst gering zu halten, können diese in ihrer Höhe so klein gebaut werden, wie es technisch und wirtschaftlich noch sinnvoll ist. So kann beispielsweise nur noch ein Solarzellen-String zu einem Solarmodul verschaltet werden. Bei gleicher installierter elektrischer Leistung wird durch das parallele Aufstellen von vielen Einstring-Solarmodulen mit geringen Flächenlasten gegenüber Standard-Solarmodulen mit hoher örtlicher Flächenlast diese gleichmäßiger auf dem Flachdach verteilt. Aber auch wenige Solarzellenreihen nebeneinander ("Mehrstring-Solarmodul" im Gegensatz zu "Vielstring-Solarmodul") ergeben immer noch sehr schmale Solarmodule mit einem großen Aspektverhältnis, das heißt mit einer großen Länge gegenüber ihrer Höhe ("brettförmige" Ausgestaltung). Solarmodule können Solarzellen auf Glasscheiben in konstruktiven Rahmen oder auch in Kunststoff eingegossene "laminierte" Solarzellen aufweisen. Solarmodule mit einlaminierten Solarzellen können auch als "Solarpaneele" bezeichnet werden und sind relativ dünn. Solarpaneele weisen in der Regel keine ausladenden Rahmenkonstruktionen auf, vielmehr werden ungenutzte Randbereiche der Solarpaneele direkt zu Montage- und Verschaltungszwecken genutzt. Die Verschaltung ist oft in das Solarpaneel integriert, sodass nur noch Anschlusskabel außerhalb des Laminats vorhanden sind. Aufgrund der geringen Windangriffsfläche von Solarmodulen mit einem großen Aspektverhältnis - die durch entsprechende Windspoiler noch verringert werden kann - wird nur eine sehr geringe Last zur Sicherung gegen das Abheben benötigt. Eine Verankerung oder Verbindung mit dem Dach ist beispielswiese nicht zwingend notwendig.

### STAND DER TECHNIK

Aus der US 6.870.087 B1 ist ein Einstring-Solarmodul in Rahmenausführung bekannt, bei dem der Rahmen drehbar in einem Gestell gelagert ist, sodass eine geneigte Ausrichtung nach der Sonne möglich ist. Eine Vielzahl von Einstring-Solarmodulen kann parallel in einem Gestell gelagert sein. Ebenso werden "Mehrstring-Solarmodule" offenbart. Desweiteren werden Mehrstring-Solarmodule in der US 6.703.555 B2 beschrieben, die auf schräge Betonwinkel aufgebracht worden sind.

Aus der WO 00/12839 A1 ist eine Montagevorrichtung für Solarmodule mit einem geringen Aspektverhältnis auf einem Schrägdach bekannt. An darauf angeordneten Montageschienen werden an durch Durchgangsöffnungen vorgegebenen Stellen Querschienen befestigt. Diese weisen an ihren einem Ende Scharniere und an ihrem anderen Ende Rasthaken auf. So können in den Scharnieren befestigte rechteckige Solarmodule bei Bedarf flachgelegt oder unter einem vorgegebenen Neigungswinkel schräg aufgestellt werden.

Der der Erfindung nächstliegende Stand der Technik, von dem die vorliegende Erfindung demgemäß auch ausgeht, wird in der JP 2000064523 A offenbart. Gezeigt wird hier eine Montagevorrichtung für Solarmodule, die aufgrund eines großen Aspektverhältnisses eine brettförmige Ausgestaltung aufweisen. Für eine optimale Einstrahlungsausnutzung sind in einer Photovoltaikanlage viele Solarmodule parallel in einem der Sonneneinstrahlung zugeneigten Aufstellungswinkel auf einer Betonfläche als flaches Horizontalsubstrat angeordnet. Die Anordnung erfolgt über eine Montagevorrichtung, die im Wesentlichen aus auf der Betonfläche angeordneten Montageschienen und daran befestigten Einschubelementen besteht. Die Montageschienen bestehen aus U-förmigen Profilen, die mit der Öffnung nach unten auf die Betonfläche geschraubt sind. In einem vorgegebenen Rastermaß weisen die Montageschienen Durchgangsöffnungen zum Festlegen der Einschubelemente auf. Jedes Einschubelement besteht aus zwei getrennten Metallwinkeln unterschiedlicher Schenkellänge, die jeweils in einer Durchgangsöffnung festgeschraubt werden. Jeder Metallwinkel weist an seinem oberen Ende eine zweifache Umbiegung zum seitlichen Einschieben der Solarmodule in ihrem Randbereich auf. Dabei ist zur Minimierung der Einschubtiefe der Solarmodule vorgesehen, dass die Einschubelemente an den seitlichen Rändern der Solarmodule angeordnet sind. Optional können die Einschubelemente ein oder zwei Solarmodule aufnehmen. Durch den Abstand der beiden Metallwinkel zueinander und durch die Differenz der Schenkellängen der beiden Metallwinkel werden die Breite und der Einschubwinkel (Neigungswinkel) der einzuschiebenden Solarmodule unveränderbar festgelegt. Eine Demontage von mittig angeordneten Solarmodulen ist nur nach Entfernen der benachbarten Solarmodule oder zumindest nach deren Verschieben bei gleichzeitiger Demontage der entsprechenden Einschubelemente möglich. Zum seitlichen Einschieben der Solarmodule ist immer ein entsprechender seitlicher Platz erforderlich. Außerdem müssen lange Solarmodule in der Regel von zwei Monteuren montiert werden, um ein Abwinkeln und Beschädigen des Solarmoduls zu verhindern.

### AUFGABENSTELLUNG

Die Aufgabe für die vorliegende Erfindung ist daher darin zu sehen, eine gattungsgemäße Montagevorrichtung der eingangs beschriebenen Art anzugeben, mit der mit einfach zu handhabenden, unempfindlichen Einschubelementen brettförmige Solarmodule in geneigter Stellung auf einem flachen Horizontalsubstrat in einfacher Weise angeordnet und zu Wartungszwecken ebenso einfach entfernt werden können. Weiterhin soll die Montagevorrichtung zur Aufnahme von Solarmodulen unterschiedlicher Höhen und Dicken geeignet sein, ohne dass andere Einschubelemente erforderlich sind. Eine einfache Anpassung der Montagevorrichtung an unterschiedliche Aufstellungswinkel der Solarmodule ist ebenfalls wünschenswert. Die erfindungsgemäße Lösung ist dem Hauptanspruch zu entnehmen. Vorteilhafte Weiterbildungen der Erfindung werden in den Unteransprüchen aufgezeigt und im Folgenden im Zusammenhang mit der Erfindung näher erläutert.

Bei der erfindungsgemäßen Montagevorrichtung ist jedes Einschubelement als kompaktes, einstückiges Formelement mit einer geschlossenen Oberfläche ausgeführt, wodurch sich eine einfache Handhabung ergibt. Weiterhin zeigen die Formelemente zum Einschieben der Solarmodule ein ästhetisches Erscheinungsbild und sind aufgrund ihrer konstruktiven Geschlossenheit weitgehend unempfindlich gegen Schmutz- und Beschädigungseinflüsse. Zur Aufnahme der Solarmodule sind die Formelemente mit einem Einschubschlitz versehen, der die ansonsten geschlossene Oberfläche durchquert und unter einem vorgegebenen Einschubwinkel verläuft. In diesen Einschubschlitz wird das Solarmodul mit einem längsverlaufenden Randbereich einfach eingeschoben, was besonders vorteilhaft ist. Zum einen ist das Einschubelement nicht mehr an die Höhe des Solarmoduls angepasst, sodass Solarmodule unterschiedlicher Höhe problemlos in ein und demselben Einschubelement befestigt werden können. Zum anderen ist kein seitliches Einschieben des Solarmoduls erforderlich. Dieses wird in einfacher Weise von oben in die für ein Solarmodul vorgesehene Anzahl von Einschubelementen eingesteckt, was auch von einem einzigen Monteur ohne eine Beschädigung problemlos vorgenommen werden kann. Die für die Befestigung vorgesehenen Stellen des Solarmoduls werden direkt in die Formelemente eingesteckt. Je nach Länge des Solarmoduls können beispielsweise nur ein Formelement mittig oder zwei Formelemente in den Endbereichen des Solarmoduls oder drei oder mehr Formelemente in gleichmäßiger Verteilung über der Länge des Solarmoduls vorgesehen sein.

Schließlich ist noch durch die von benachbarten Solarmodulen völlig unabhängige Montageweise besonders gut dafür geeignet, einzelne Solarmodule im Betrieb zu warten. Es kann eine einfache Demontage ausschließlich des betroffenen Solarmoduls erfolgen. Ein Austausch von Solarmodulen ist ebenfalls einfach möglich. Festgelegt wird das eingeschobene Solarmodul bei der Erfindung durch Einschieben eines einfachen Kunststoffkeils, der dieses gegenüber dem Einschubelement festklemmt. Aufgrund der geringen Angriffsfläche gegenüber Windlasten wegen ihres hohen Aspektverhältnisses benötigen brettförmige Solarmodule nur eine geringe Fixierungskraft. Diese kann problemlos von den genannten Kunststoffkeilen bei der Erfindung aufgebracht werden. Durch Variation der Breite des Kunststoffkeils oder bevorzugt durch eine elastische Ausführung des Kunststoffkeils ist weiterhin eine einfache Anpassung des Einschubelements an Solarmodule unterschiedlicher Dicke möglich.

Die erfindungsgemäße Montagevorrichtung kann eine Reihe von vorteilhaften, unterschiedlichen Modifikationen unterworfen werden, die die Praktikabilität und Vielseitigkeit der Erfindung bei gleichzeitig großer Einfachheit noch unterstreichen. Es können sowohl rahmenbehaftete als auch rahmenlose Solarmodule montiert werden. Insbesondere bei einer Ausführung der Solarmodule als rahmenlose Solarpaneele kommt deren geringe Dicke dem Montageprinzip bei der Erfindung sehr entgegen, sodass die Verwendung von Solarpaneelen bei der Erfindung bevorzugt wird. Weiterhin können die Solarmodule in einem beliebigen Neigungswinkel zur Sonne aufgestellt werden. Eine entsprechende Ausrichtung des Einschubschlitzes in den Formelementen kann bei deren Herstellung problemlos erfolgen. Beispielsweise kann zur Einstrahlung in eine Oberfläche der Solarmodule ein Neigungswinkel von 35° zum Horizontalsubstrat gewählt werden. Es kann aber auch ein Neigungswinkel von 0° gewählt werden, sodass die Solarmodule dann senkrecht und somit orthogonal zum Horizontalsubstrat angeordnet sind. Eine derartige Anordnung eignet sich besonders, wenn bifaciale Solarmodule, deren Solarzellen Sonneinstrahlung von beiden Seiten her verarbeiten können, eingesetzt werden. Für eine weitere Verbesserung der Einstrahlungsnutzung können dann zwischen den Solarmodulen entsprechende Reflektoren in horizontaler oder geneigter Ausführungsform vorgesehen sein.

Weiterhin kann gemäß einer vorteilhaften Ausführungsform der Erfindung der Kunststoffkeil in einen an den Einschubschlitz angrenzenden Festlegschlitz hineingreifen, wobei der Festlegschlitz eine größere Tiefe als der Einschubschlitz aufweist. Dadurch vergrößert sich die Abstützfläche für den Kunststoffkeil, sodass eine sichere Festlegung des Solarmoduls im Einschubschlitz erreicht werden kann. Die Demontage des Solarmoduls erfolgt jeweils nach vorheriger Entnahme des Kunststoffkeils. Weiterhin kann der Einschubschlitz eine Kabeldurchführung in den Innenraum des Formelements aufweisen. Von hier aus können die Kabel dann einfach weitergeleitet werden. Die geschlossene Oberfläche der eingesetzten Formelemente bleibt bei dieser Ausführungsform ungestört, da keine Kabel sichtbar sind. Weiterhin ergibt sich eine Verbesserung der Betriebssicherheit, da die Kabel geschützt innerhalb der Formelemente verlaufen können. Die Betriebssicherheit kann dabei noch weiter erhöht werden, wenn vorteilhaft das Formelement im Innenraum eine Kabelzugentlastung aufweist. Eine Trennung des Kabels vom Solarmodul durch übermäßige Kraftweinwirkung ist damit sicher vermieden. Auf der Anschlussstelle des Kabels zum Solarmodul lastet keine Zugkraft. Schließlich kann die Ungestörtheit der Außenkontur der Formelemente und damit das ästhetische Erscheinungsbild auch dadurch erhalten werden, dass sich der Kunststoffkeil formschlüssig an die Außenkontur des Formelements anschließt. Bei dem Kunststoffkeil kann es sich um ein einfaches vorkonfektioniertes Montageelement handeln, das einfach in den Einsteckschlitz eingesteckt und verkeilt wird. Eine einfache Methode zum Einbringen des Kunststoffkeils kann aber auch darauf beruhen, dass der Kunststoffkeil von nach dem Einschieben des Solarmoduls in den Festlegschlitz eingebrachter Vergussmasse gebildet ist. Wenn beispielsweise der Festlegschlitz eine Einfüllöffnung zum Einbringen der Vergussmasse vom Innenraum des Formelements her aufweist, kann durch diese Öffnung Vergussmasse, beispielsweise Silikonmasse, einfach eingespritzt werden. Wenn vorher eine Schablone auf die Oberseite des Formelements aufgesetzt wird, kann erreicht werden, dass der Kunststoffkeil formschlüssig mit der Oberseite des Formelements abschließt. Eine nachträgliche Formanpassung der eingebrachten Vergussmasse beispielsweise durch einfaches Abschneiden mit dem Messer ist aber auch ohne weiteres möglich.

Weiterhin ist es vorteilhaft, wenn zum passgenauen Aufsetzen der Formelemente auf die Montageschienen die Formelemente auf ihrer Unterseite Führungsnuten aufweisen, die in entsprechende Führungsleisten in der Montageschiene eingreifen. Für eine einfache Montage der Formelemente ist es vorteilhaft, wenn jedes Formelement über zumindest eine Durchgangsöffnung an der Montage schiene befestigt ist, indem ein Winkelelement von unten durch die Durchgangsöffnung greift, das in dem durchgreifenden Schenkel eine Positivausnehmung aufweist, in die eine Negativausnehmung auf der Unterseite des Formelements eingreift. Das Eingreifen der Negativausnehmungen an den Formelementen in die Positivausnehmungen der Winkelelemente kann beispielsweise durch eine geringe Längsverschiebung der Formelemente auf den Führungsleisten der Montageschienen erfolgen.

Wesentlicher Aspekt neben der guten Handhabbarkeit der Formelemente bei der Erfindung sind auch deren Störunempfindlichkeit und das ästhetische Erscheinungsbild. Bekannte Einschubelemente entsprechen diesen Aspekten nicht, da sie als einfache Haken ausgebildet sind. Bei der Erfindung können die Formelemente bevorzugt halbschalenförmig ausgebildet sein, wobei im Innenraum zentral eine Stützwand verläuft. Es ergibt sich eine besonders kompakte, aber funktionelle Form, die an das Erscheinungsbild einer Computermaus erinnern kann. Im Gegensatz zu einer Vollelementausbildung zeigt eine halbschalenförmige Ausbildung der Formelemente ein geringeres Gewicht und eine bessere Handhabbarkeit, insbesondere eine bessere Zugänglichkeit von der Innenseite her. Die zentrale Stützwand sorgt dabei für die erforderliche mechanische Festigkeit. Vorteilhaft kann die Stützwand noch die Negativausnehmung, die Kabelzugentlastung und/oder eine Führungsnut aufweisen. Eine weitere Formverbesserung ergibt sich, wenn das Formelement an beiden Längsseiten offen ist, insbesondere ergibt sich eine optimale Zugänglichkeit des Innenraums, auch im montierten Zustand. Durch die Formgebung und die gemäßigten Kraftverhältnisse aufgrund der geringen Windlasten bietet es sich schließlich an, die Formelemente aus Kunststoff herzustellen, beispielsweise als einfache Spritzgussteile. Bei einem grünen Kunststoff können die Formelemente dann an Frösche erinnern, sodass die Bezeichnung "solfrog" gewählt werden kann.

Bereits weiter oben wurde ausgeführt, dass die Anzahl der vorgesehenen Formelemente pro Solarmodul abhängig von dessen Länge ist. Sehr kurze Solarmodule können in einziges Formelement zentral eingeschoben werden. Für eine kippfreie Lagerung ist es jedoch vorteilhaft, wenn pro Solarmodul zumindest zwei Formelemente vorgesehen sind, die in zwei zueinander beabstandeten, parallelen Montageschienen befestigt sind.

Die Montageschienen können zur Gewichtsverringerung und zur Wasserableitung ein gerastertes Lochmuster aufweisen, wobei im Bereich der Durchgangsöffnungen dann kein Lochmuster vorgesehen ist, um eine sicherer Befestigung der Formelemente zu gewährleisten. Weiterhin können die Montageschienen hochgebogene Seitenränder aufweisen. Wird jetzt das ein in seiner Breite entsprechend bemessenes Formelement zentral in der Montageschiene angeordnet, entsteht zwischen dem Formelement und jedem Seitenrand eine Kabelführungsrinne, in der vorteilhaft die aus dem Innenraum der Formelemente kommenden Kabel gesammelt und geführt werden können. Für eine Anpassung der Länge der Montageschienen an die Größe des Horizontalsubstrat ist es weiterhin vorteilhaft, wenn die Montageschienen an ihrem vorderen und hinteren Ende Anschlusselemente für weitere Montageschienen aufweisen, sodass ein einfaches Anstecken, beispielsweise über Zapfen und Nut, zur Verlängerung möglich ist. Durch die beliebige Anordnung der Montageschienen nebeneinander und durch deren Längenanpassung an das Substrat ist es möglich, das gesamte Substrat mit einer Solaranlage aus einer Vielzahl von parallelen und seriellen Solarmodulen zu versehen. Dabei müssen die Montageschienen aufgrund der geringen Windangriffskraft nicht unbedingt am Substrat befestigt werden, beispielsweise durch Schrauben. Trotzdem erhöht eine Fixierung die Betriebssicherheit des Systems und kann beispielsweise bevorzugt dadurch erfolgen, dass die Montageschienen durch eine Kies- oder Sandschüttung auf dem Horizontalsubstrat fixiert werden.

Weitere Details der Montagevorrichtung für Solarmodule mit einem großen Aspektverhältnis sind dem nachfolgenden Ausführungsbeispiel zu entnehmen. Auch wenn es sich bei dem Ausführungsbeispiel um eine bevorzugte Ausführungsform der erfindungsgemäßen Montagevorrichtung handelt, ist diese nicht darauf beschränkt. Vielmehr ergeben sich vielfältige Ausgestaltungsmöglichkeiten für die erfindungsgemäße Montagevorrichtung, basierend auf der Grundidee eines kompakten Formelements als Einschubelement mit einem Einschubschlitz.

### AUSFÜHRUNGSBEISPIEL

Eine bevorzugte Ausbildungsform der Montagevorrichtung für Solarmodule nach der Erfindung wird nachfolgend anhand der schematischen Figuren näher erläutert. Dabei zeigt:
- **FIGUR 1**: eine perspektivische Ansicht der Montagevorrichtung,
- **FIGUR 2A**: eine Seitenansicht der Montagevorrichtung,
- **FIGUR 2B**: einen Schnitt der Montagevorrichtung,
- **FIGUR 2C**: eine perspektivische Ansicht eines Details der Montagevorrichtung,
- **FIGUR 3A**: eine Seitenansicht des Formelements,
- **FIGUR 3B**: eine perspektivische Ansicht in den Innenraum des Formelements,
- **FIGUR 4**: eine perspektivische Ansicht der Montageschiene,
- **FIGUR 5A**: eine Frontansicht der Montagevorrichtung mit Bemaßung und
- **FIGUR 5B**: eine Seitenansicht der Montagevorrichtung mit Bemaßung.

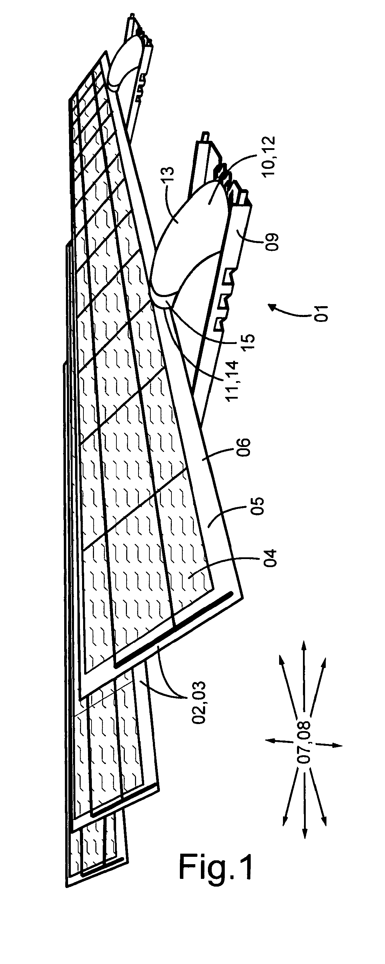

Die **FIGUR 1** zeigt eine perspektivische Ansicht der Montagevorrichtung **01** nach der Erfindung. Die Montagevorrichtung **01** ist geeignet für die Montage von Solarmodulen **02** mit einem großen Aspektverhältnis, d.h. mit einer gegenüber der Höhe sehr großen Länge. Gezeigt ist ein Einstring-Solarmodul **03** mit einer einzigen Reihe kristalliner Solarzellen **04.** Einstring-Solarmodule **03** sind brettförmig ausgestaltet und haben den Vorteil einer geringen Höhe, sodass die Windangriffslasten entsprechend gering sind. Weiterhin ist das gezeigte Einstring-Solarmodul **03** als rahmenloses Solarpaneel **05** ausgebildet, dessen Randbereich **06** zur Montage genutzt wird. Eine Vielzahl von Solarmodulen **02** ist in Parallelanordnung auf einem flachen Horizontalsubstrat **07,** hier ein Flachdach **08,** angeordnet. Gezeigt ist eine geneigte Anordnung zur optimalen Ausrichtung einer Oberfläche der Solarmodule **03** in Richtung der hauptsächlichen Sonneneinstrahlung. Eine senkrechte Anordnung der Solarmodule **03** (Einschubwinkel 0°) orthogonal zum Horizontalsubstrat **07** ist ebenfalls möglich. Dies ist vorteilhaft, wenn bifaciale Solarzellen eingesetzt werden, die auf beiden Oberseiten photovoltaisch aktiv sind. Zwischen den Solarmodulen **03** können dann Reflektoren vorgesehen sein.

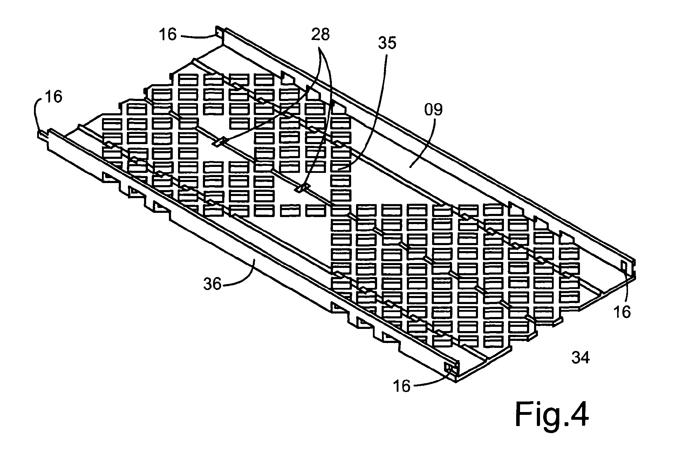

Die Montagevorrichtung **01** besteht in der Hauptsache aus Montageschienen **09** und an den Montageschienen **09** an durch Durchgangsöffnungen (vergleiche **FIGUR 4****)** vorgegebenen Stellen befestigten Einschubelementen **10** zum Einschieben und Festlegen der Solarmodule **02** in ihrem Randbereich **06.** Gezeigt ist eine Montage mittels zwei Einschubelementen **10** pro Solarmodul **02,** die in zwei zueinander beabstandeten, parallelen Montageschienen **09** befestigt sind. Jedes Einschubelement **10** ist bei der Erfindung als kompaktes, einstückiges Formelement **12** mit einer geschlossenen Oberfläche **13** ausgeführt ist, die von einem unter einem vorgegebenen Einschubwinkel **11** verlaufenden Einschubschlitz **14** unterbrochen ist. In den Einschubschlitz **14** wird das Solarmodul **02** mit seinem längsverlaufenden Randbereich **06** eingeschoben und durch einen Kunststoffkeil **15** festgelegt.

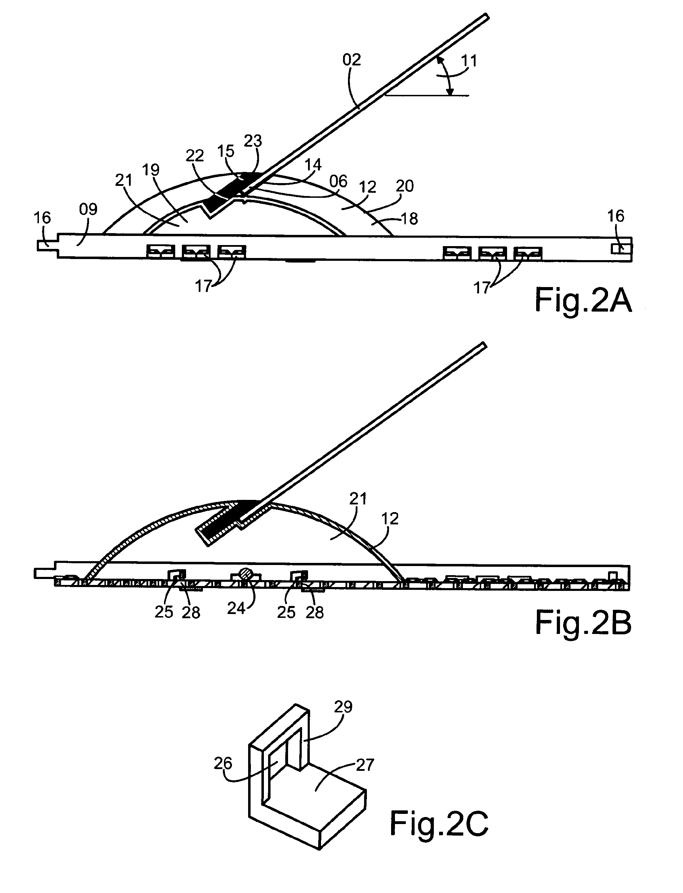

In der **FIGUR 2A** sind die Montageschiene **09** und ein kompaktes einstückiges Formelement **12** in der Seitenansicht dargestellt. Die Montageschiene **09** weist an ihren Enden Anschlusselemente **16,** hier Zapfen und Nut, zum Anschluss an weitere Montageschienen **09** auf. Weiterhin sind Durchbrüche **17** für eine Gewichtsminimierung zu erkennen (vergleiche **FIGUR 4****).** Das Formelement **12** besteht aus einer an beiden Längsseiten **19** offenen Halbschale **18** mit einer geschlossenen Oberfläche **20.** Unterhalb der offenen Längsseiten **19** ist eine zentrale Stützwand **21** zu erkennen. Die Oberfläche **20** ist durchbrochen von dem Einschubschlitz **14,** der im gezeigten Ausführungsbeispiel geneigt angeordnet ist. In den Einschubschlitz **14** ist das Solarmodul **02** mit seinem Randbereich **06** eingeschoben und somit unter dem Einschubwinkel **11** des Einschubschlitzes **14** positioniert. Der Kunststoffkeil **15** ist in einen benachbarten Festlegschlitz **22** eingebracht und klemmt das Solarmodul **02** fest. Dabei weist zur weiteren Stabilisierung der Festlegschlitz **22** eine größere Tiefe als der Einschubschlitz **14** auf. Durch die Offenheit zwischen Einschubschlitz **14** und Festlegschlitz **22** können unterschiedlich dicke Solarmodule **02** eingeschoben und durch einen entsprechenden Kunststoffkeil **15** festgelegt werden. Dazu kann dieser entweder auch unterschiedlichen Dicken oder elastisch ausgebildet sein, sodass sich eine Klemmung durch Verformung ergibt. Bei Verwendung von Silikonmasse für den Kunststoffkeil **15** erfolgt die Festlegung des Solarmoduls **02** auch noch durch (lösbare) Verklebung. Der Kunststoffkeil **15** ist auf seiner Außenseite formschlüssig an die Außenkontur **23** des Formelements **12** angepasst.

Die **FIGUR 2B** zeigt einen Längsschnitt durch das Formelement **12** im Bereich der zentralen Stützwand **21.** Zu erkennen ist in der Mitte eine Kabelzugentlastung **24** für die Anschlusskabel des Solarmoduls **02.** Weiterhin sind zwei Negativausnehmungen **25** gezeigt, die in Positivausnehmungen **26** von Winkelelementen **27** eingreifen, wie im Detail gemäß **FIGUR 2C** gezeigt. Die Winkelelemente **27** wiederum greifen von unten durch Durchgangsöffnungen **28** in der Montageschiene **09** (vergleiche **FIGUR 4****)**. In dem durchgreifenden Schenkel **29** des Winkelelements **27** befindet sich die Positivausnehmung **26.** Durch seitliches Verschieben des Formelements **12** greifen gleichzeitig alle Negativausnehmungen **25** in der Stützwand **21** des Formelements **12** in die Positivausnehmungen **26** der durch die Montageschiene **09** hindurchgreifenden Winkelelemente **27** und verriegeln damit das Formelement **12** mit der Montageschiene **09.** Ein Lösen der Formelemente **12** ist in einfacher Weise durch entsprechendes Zurückschieben des Formelements **12** möglich. Schwer handhabbare Verschraubungen sind zur Verbindung des Formelements **12** mit der Montageschiene **09** vermieden.

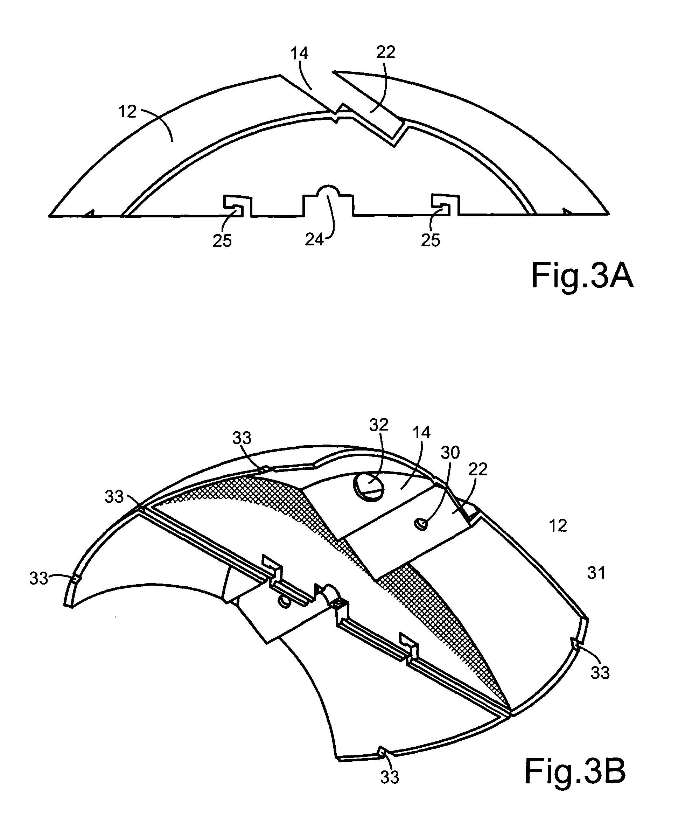

In der **FIGUR 3A** ist eine Seitenansicht der Formelements **12** ohne die Montageschiene **09** und das Solarmodul **02** dargestellt. Zu erkennen sind der Einschubschlitz **14** und der Festlegschlitz **22,** die Negativausnehmungen **25** und die Aussparung für die Kabelzugentlastung **24.** Die **FIGUR 3B** zeigt eine perspektivische Unteransicht des Formelements **12.** Im Bereich des Festlegschlitzes **22** ist eine Einfüllöffnung **30** zum Einbringen von Vergussmasse vom Innenraum **31** des Formelements **12** angeordnet. Nach dem Einschieben des Solarmoduls **02** kann durch diese Einfüllöffnung **30** beispielweise Silikon eingepresst werden, um den Kunststoffkeil **15** zu erzeugen. Im Bereich der Einschubschlitzes **14** ist eine Kabeldurchführung **32** in den Innenraum **31** des Formelements **12** angeordnet. Das durchgezogene Kabel (in der **FIGUR 3B** nicht dargestellt) kann direkt zusammen mit dem Kunststoffkeil **15** vergossen werden, sodass sich eine wasserdichte Durchführung ergibt. Weiterhin ist in der **FIGUR 3B** zu erkennen, dass das Formelement **12** auf seiner Unterseite Führungsnuten **33** aufweist, die der richtigen axialen Positionierung des Formelements **12** auf der Montageschiene **09** dienen. Seitliche Führungsnuten **33** werden von Einkerbungen in der Wandung des Formelements **12** gebildet, eine mittlere Führungsnut **33** verläuft genau in der zentralen Stützwand **21.**

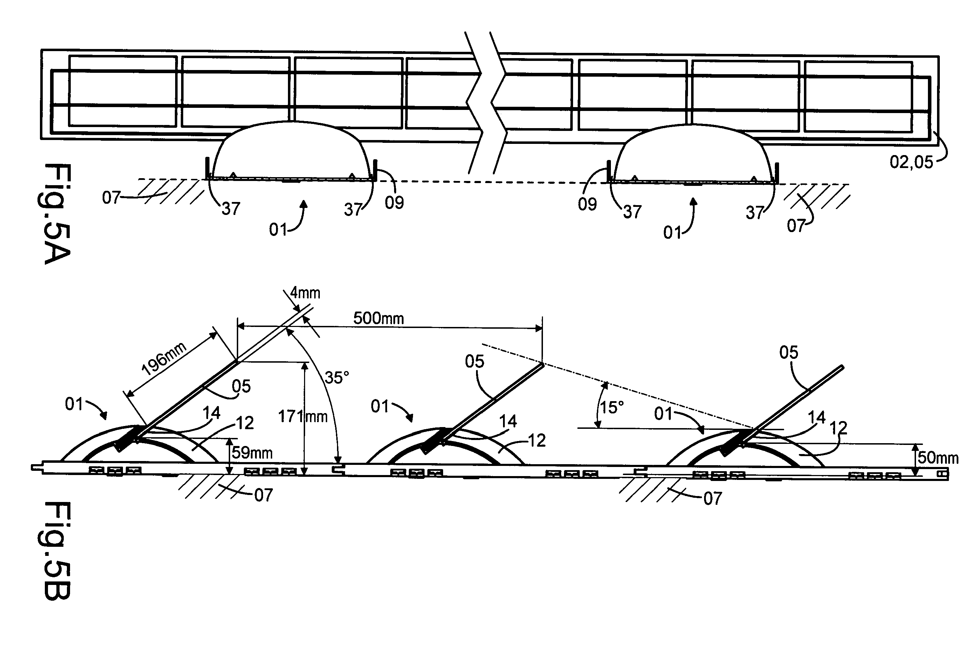

In der **FIGUR 4** ist perspektivisch eine Montageschiene **09** gezeigt. Zu erkennen sind Führungsleisten **34,** in die die Führungsnuten **33** der Formelemente **12** eingreifen können. Weiterhin weist die Montageschiene **09** neben den für die Winkelelemente **27** vorgesehenen Durchgangsöffnungen **28** (hier immer zwei pro Formelement **12)** ein gerastertes Lochmuster **35** auf, das einer Gewichtsreduzierung und damit einer leichteren Handhabung dient. Außerdem kann Wasser leichter abfließen, sodass sich keine Staunässe bildet. Im Bereich der Durchgangsöffnungen **28** ist zu deren Stabilisierung kein Lochmuster **35** vorgesehen. Die Montageschiene **09** weist hochgebogene Seitenränder **36** auf. In der **FIGUR 5A** ist zu erkennen, dass die Formelemente **12** zentral in der Montageschiene **09** angeordnet sind, sodass sich rechts und links vom Formelement **12** jeweils eine Kabelführungsrinne **37** (siehe **FIGUR 5A****)** ergibt. In diesen Kabelführungsrinnen **37** können die in den Innenraum **31** des Formelements **12** durchgeführten Anschlusskabel der Solarmodule **02** einfach weitergeführt werden. An den hochgebogenen Seitenrändern **36** weist die Montageschiene Anschlusselement **16,** hier Zapfen und Nut, zum Anschluss an weitere Montageschienen **09** auf. Fixiert werden kann die Montageschiene **09** beispielswiese durch Verschraubungen mit dem Horizontalsubstrat **07,** wobei dies relativ aufwändig ist und sich Verletzungen der Dachhaut ergeben. Aufgrund der geringen Windangriffslasten reicht auch einer weniger feste, einfach entfern- und wieder anbringbare Fixierung, beispielsweise durch eine Kies- oder Sandschüttung. Diese wird aufgebracht, nachdem alle Solarmodule **02** montiert und die Anschlusskabel verlegt worden sind.

Den **FIGUREN 5A** und **5B** sind einige Bemaßungsangaben zur Veranschaulichung der Größenverhältnisse zu entnehmen. In der **FIGUR 5A** ist eine Frontalansicht der Montagevorrichtung **01** nach der Erfindung mit zwei Montageschienen **09** und zwei Formelementen **12** für ein brettförmiges Solarmodule **02** in einer Ausbildung als Solarpaneel **05** mit einer Länge von 2094 mm, einer Höhe von 196 mm und einer Dicke von 4 mm dargestellt. Die zwei Formelemente **12** sind an den äußeren Viertelpunkten des Solarmoduls **02** angeordnet.

Die **FIGUR 5B** schließlich zeigt Bemaßungen in der Seitenansicht. Die Außenkante der Formelemente **12** erreicht eine Höhe von 58,92 mm, der Einschubwinkel **11** beträgt 35° zum Horizontalsubstrat **07,** sodass das obere Ende des Solarpaneels **05** einen Abstand von 171,34 mm zum Horizontalsubstrat **07** hat. Die Formelemente **12** ("Solfrog" aus grünem Kunststoff) haben eine Höhe von 70 mm und eine Breite von 150 mm. Der Einschubschlitz **14** hat eine Tiefe von 20 mm. Die einzelnen Formelemente **12** sind mit einem Abstand von 500 mm zueinander angeordnet, sodass sich eine kompakte Solaranlage mit einer Vielzahl von parallel angeordneten Solarmodulen **02** ergibt. Besonders vorteilhaft bei dieser Ausführung einer Solaranlage ist deren geringen Windangriffsfläche, sodass für die relativ geringen auftretenden Kräfte die Montagevorrichtung **01** nach der Erfindung eingesetzt werden kann, die besonders leicht und einfach zu handhaben ist und darüber hinaus noch einen hohen ästhetischen Erscheinungswert hat.

### BEZUGSZEICHENLISTE

- **01**: Montagevorrichtung
- **02**: Solarmodul
- **03**: Einstring-Solarmodul
- **04**: Solarzelle
- **05**: Solarpaneel
- **06**: Randbereich
- **07**: Horizontalsubstrat
- **08**: Flachdach
- **09**: Montageschiene
- **10**: Einschubelement

- **11**: Einschubwinkel
- **12**: Formelement
- **13**: Oberfläche
- **14**: Einschubschlitz
- **15**: Kunststoffkeil
- **16**: Anschlusselement
- **17**: Durchbruch
- **18**: Halbschale
- **19**: Längsseite

- **20**: Oberfläche
- **21**: Stützwand
- **22**: Festlegschlitz
- **23**: Außenkontur
- **24**: Kabelzugentlastung
- **25**: Negativausnehmung
- **26**: Positivausnehmung
- **27**: Winkelelement

- **28**: Durchgangsöffnung
- **29**: Schenkel
- **30**: Einfüllöffnung

- **31**: Innenraum
- **32**: Kabeldurchführung
- **33**: Führungsnut
- **34**: Führungsleiste
- **35**: Lochmuster
- **36**: Seitenrand
- **37**: Kabelführungsrinne

## Patentansprüche

1. Montagevorrichtung (01) für Solarmodule (02) mit einem großen Aspektverhältnis in Parallelanordnung auf einem flachen Horizontalsubstrat (07) mit darauf angeordneten Montageschienen (09) und an den Montageschienen (09) an durch Durchgangsöffnungen (28) vorgegebenen Stellen befestigten Einschubelementen (10) zum Einschieben und Festlegen der Solarmodule (02) in ihrem Randbereich (06),
**DADURCH GEKENNZEICHNET, DASS**
jedes Einschubelement (10) als kompaktes, einstückiges Formelement (12) mit einer geschlossenen Oberfläche (13) ausgeführt ist, die von einem unter einem vorgegebenen Einschubwinkel (11) verlaufenden Einschubschlitz (14) unterbrochen ist, in dem das mit einem längsverlaufenden Randbereich (06) eingeschobene Solarmodul (02) durch einen Kunststoffkeil (15) festgelegt ist.

2. Montagevorrichtung nach Anspruch 1,
**DADURCH GEKENNZEICHNET, DASS**
das Solarmodul (02) als Solarpaneel (05) ausgeführt ist.

3. Montagevorrichtung nach Anspruch 1,
**DADURCH GEKENNZEICHNET, DASS**
der Einschubwinkel (11)0° beträgt und bifaciale Solarmodule (02) mit sonnenaktiven Einstrahflächen auf beiden Oberseiten eingeschoben werden.

4. Montagevorrichtung nach Anspruch 1,
**DADURCH GEKENNZEICHNET, DASS**
der Kunststoffkeil (15) in einem an den Einschubschlitz (14) angrenzenden Festlegschlitz (22) hineingreift, der eine größere Tiefe als der Einschubschlitz (14) aufweist.

5. Montagevorrichtung nach Anspruch 1,
**DADURCH GEKENNZEICHNET, DASS**
der Kunststoffkeil (15) elastisch ausgebildet ist.

6. Montagevorrichtung nach Anspruch 1,
**DADURCH GEKENNZEICHNET, DASS**
sich der Kunststoffkeil (15) formschlüssig an die Außenkontur (23) des Formelements (12) anschließt.

7. Montagevorrichtung nach Anspruch 1,
**DADURCH GEKENNZEICHNET, DASS**
der Einschubschlitz (14) eine Kabeldurchführung (32) in den Innenraum (31) des Formelements (12) aufweist.

8. Montagevorrichtung nach Anspruch 1,
**DADURCH GEKENNZEICHNET, DASS**
das Formelement (12) im Innenraum (31) eine Kabelzugentlastung (24) aufweist.

9. Montagevorrichtung nach Anspruch 1,
**DADURCH GEKENNZEICHNET, DASS**
der Kunststoffkeil (15) von nach dem Einschieben des Solarmoduls (02) in den Festlegschlitz (22) eingebrachter Vergussmasse gebildet ist.

10. Montagevorrichtung nach Anspruch 9,
**DADURCH GEKENNZEICHNET, DASS**
der Festlegschlitz (22) eine Einfüllöffnung (30) zum Einbringen der Vergussmasse vom Innenraum (31) des Formelements (12) her aufweist.

11. Montagevorrichtung nach Anspruch 1,
**DADURCH GEKENNZEICHNET, DASS**
das Formelement (12) auf seiner Unterseite Führungsnuten (33) aufweist, die in entsprechende Führungsleisten (34) in der Montageschiene (09) eingreifen.

12. Montagevorrichtung nach Anspruch 1,
**DADURCH GEKENNZEICHNET, DASS**
jedes Formelement (12) über zumindest eine Durchgangsöffnung (28) an der Montageschiene (09) befestigt ist, indem ein Winkelelement (27) von unten durch die Durchgangsöffnung (28) greift, das in dem durchgreifenden Schenkel (29) eine Positivausnehmung (26) aufweist, in die eine Negativausnehmung (25) auf der Unterseite des Formelements (12) eingreift.

13. Montagevorrichtung nach Anspruch 1,
**DADURCH GEKENNZEICHNET, DASS**
das Formelement (12) halbschalenförmig ausgebildet ist, wobei im Innenraum (31) zentral eine Stützwand (21) verläuft.

14. Montagevorrichtung nach Anspruch 13 und 8, 11 und/oder 12,
**DADURCH GEKENNZEICHNET, DASS**
die Stützwand (21) die Negativausnehmung (25), die Kabelzugentlastung (24) und/oder eine Führungsnut (33) aufweist.

15. Montagevorrichtung nach Anspruch 13,
**DADURCH GEKENNZEICHNET, DASS**
das Formelement (12) an beiden Längsseiten (19) offen ist.

16. Montagevorrichtung nach Anspruch 1,
**DADURCH GEKENNZEICHNET, DASS**
das Formelement (12) aus Kunststoff ist.

17. Montagevorrichtung nach Anspruch 1,
**DADURCH GEKENNZEICHNET, DASS**
pro Solarmodul (02) zumindest zwei Formelemente (12) vorgesehen sind, die in zwei zueinander beabstandeten, parallelen Montageschienen (09) befestigt sind.

18. Montagevorrichtung nach Anspruch 1,
**DADURCH GEKENNZEICHNET, DASS**
die Montageschiene (09) ein gerastertes Lochmuster (35) aufweist, wobei im Bereich der Durchgangsöffnungen 28) kein Lochmuster (35) vorgesehen ist.

19. Montagevorrichtung nach Anspruch 1,
**DADURCH GEKENNZEICHNET, DASS**
die Montageschiene (09) hochgebogene Seitenränder (36) aufweist, wobei das Formelement (12) zentral in der Montageschiene (09) angeordnet ist und eine solche Breite aufweist, dass zwischen dem Formelement (12) und jedem Seitenrand (36) eine Kabelführungsrinne (37) entsteht.

20. Montagevorrichtung nach Anspruch 1,
**DADURCH GEKENNZEICHNET, DASS**
die Montageschiene (09) an ihrem vorderen und hinteren Ende Anschlusselemente (16) für weitere Montageschienen (09) aufweist.

21. Montagevorrichtung nach Anspruch 1,
**DADURCH GEKENNZEICHNET, DASS**
die Montageschiene (09) durch eine Kies- oder Sandschüttung auf dem Horizontalsubstrat (07) fixiert ist.

22. Montagevorrichtung nach Anspruch 2,
**DADURCH GEKENNZEICHNET, DASS**
für rahmenlose Solarpaneele (05) mit einer Länge in einem Bereich von 2000 mm, einer Höhe in einem Bereich von 200 mm und einer Dicke in einem Bereich von 4 mm die Formelemente (12) eine Höhe in einem Bereich von 70 mm, eine Breite in einem Bereich von 150 mm und einen unter einem Einschubwinkel (11) von 35° zum Horizontalsubstrat (07) verlaufenden Einschubschlitz (14) mit einer Einschubtiefe in einem Bereich von 20 mm sowie einen Abstand in einem Bereich 500 mm für die Parallelanordnung mehrerer Solarpaneele (05) aufweisen.
